# FASCICULE DE BREVET EUROPEEN

(11) **EP 3 651 195 B1**
(45) Date de publication et mention de la délivrance du brevet: **08.09.2021**
(21) Numéro de dépôt: 19207066.2
(22) Date de dépôt: 05.11.2019
(51) Int. Cl.: H01L 23/473

(54) **PROCÉDÉ DE FABRICATION D'UN CIRCUIT DE REFROIDISSEMENT**
HERSTELLUNGSVERFAHREN EINES KÜHLKREISLAUFS
METHOD FOR MANUFACTURING A COOLING CIRCUIT

(30) Priorité: 07.11.2018 FR 1860240
(43) Date de publication de la demande: 13.05.2020
(73) Titulaire: Commissariat à l'Energie Atomique et aux Energies Alternatives, 75015 Paris (FR)
(72) Inventeur: COLLIN, Louis-Michel, 38054 Grenoble Cedex 9 (FR); COLONNA, Jean-Philippe, 38054 Grenoble Cedex 9 (FR); COUDRAIN, Perceval, 38054 Grenoble Cedex 9 (FR); FRECHETTE, Luc, 38054 Grenoble Cedex 9 (CA)
(74) Mandataire: Decobert, Jean-Pascal

(56) Documents cités:
- WO-A1-2012/005706
- US-A1- 2014 227 147
- US-A1- 2016 172 278
- US-B1- 6 919 231

## Description

### DOMAINE DE L'INVENTION

La présente invention concerne les dispositifs microélectroniques et leur fabrication. Par dispositif microélectronique, on entend tout type de dispositif réalisé avec les moyens de la microélectronique. Ces dispositifs englobent, notamment en plus des dispositifs à finalité purement électronique, des dispositifs micromécaniques ou électromécaniques (MEMS, NEMS...) ainsi que des dispositifs optiques ou optoélectroniques (MOEMS...).

Particulièrement, le refroidissement de puces à circuits intégrés formant ou compris dans de tels dispositifs est concerné. Notamment, l'invention permet la création d'un circuit de refroidissement, ce circuit pouvant être utilisé en conjonction avec un fluide caloporteur.

### ARRIERE-PLAN TECHNOLOGIQUE

Les circuits électroniques sont générateurs d'une énergie calorifique qui doit être dissipée. Certains composants sont de faible puissance et la chaleur peut être évacuée par les éléments de raccordement électrique qui sont de bons conducteurs de chaleur, tels que des organes de connexion, comme des plots de cartes à circuits intégrés (appelées PCB, pour « Printed Circuit Board » en anglais). Pour les composants à plus forte puissance, on a souvent recours à des dissipateurs à ailettes offrant une surface d'échange thermique accrue à l'arrière des composants. Le reste des puces est généralement enrobé par une couche de résine servant à l'encapsulation et protégeant la puce.

On connait en outre de la publication brevet FR3030112 A1, un procédé de fabrication d'un assemblage entre une puce et une plaque de support, ce procédé comprenant une réalisation de murs métalliques définissant des canaux, suivie d'un dépôt de résine sacrificielle entre les murs métalliques puis d'un assemblage de la puce et de la plaque, ces étapes faisant en sorte que les canaux aient des sections fermées définies par les murs et les faces en regard de la puce et de la plaque. La résine est ensuite éliminée et les canaux s'en trouvent ouverts. Un refroidissement est permis au travers des canaux mais au prix d'un procédé assez complexe (notamment par les murs métalliques) et intimement lié à la phase d'assemblage de la puce et de la plaque.

La publication brevet WO 2012/005706 A1 divulgue un circuit de refroidissement à la surface d'un système micro-électronique. Il utilise des parois latérales formées par électrodéposition délimitant un espace d'intégration d'un matériau sacrificiel et destiné à former des canaux de refroidissement.

Il existe donc actuellement un besoin pour un procédé de réalisation alternatif de canaux de refroidissement d'une puce.

C'est un objet de l'invention que de pallier au moins en partie les inconvénients des techniques actuelles pour y parvenir.

### RESUME DE L'INVENTION

Un aspect non limitatif de l'invention est relatif à un procédé de fabrication d'un circuit de refroidissement sur au moins une puce à circuits intégrés, comprenant une réalisation d'un circuit de refroidissement sur une première face de la puce.

Avantageusement, le procédé est caractérisé par le fait que la réalisation du circuit de refroidissement comprend :
- une formation d'un motif de définition du circuit de refroidissement situé au moins en partie sur la première face de la puce, ledit motif comprenant au moins une couche d'un matériau sacrificiel ;
- une formation d'un enrobage dudit motif par au moins une couche de résine ;
- une élimination, au moins partielle, du matériau sacrificiel dudit motif, de sorte à ouvrir le circuit de refroidissement.

Un autre aspect séparable de la présente invention concerne un dispositif microélectronique comprenant au moins une puce à circuits intégrés, un circuit de refroidissement et un support.

Avantageusement ce dispositif est tel que le circuit de refroidissement est situé sur une première face de la puce, la puce étant assemblée par une deuxième face de la puce, opposée à la première face de la puce, à une première face du support, les parois du circuit de refroidissement étant définies, pour une première des parois par la première face de la puce, et pour les autres des parois par des canaux formés dans un enrobage en résine.

De préférence, ce dispositif est obtenu par le procédé de l'invention.

Ainsi, les canaux du circuit de refroidissement sont définis dans de la résine d'enrobage. Cela simplifie grandement leur fabrication, évitant notamment des étapes complexes de lithographie et de gravure. De plus, l'enrobage est, de préférence, celui utilisé pour *packager* la puce, c'est-à-dire pour constituer un boitier l'entourant au moins partiellement. Ce n'est donc pas une partie supplémentaire dans ce cas.

Alors que la technique actuelle s'oriente vers des solutions de dissipation thermique essentiellement via les matériaux de la puce, notamment silicium ou métaux, car ils sont bons conducteurs de chaleur, l'invention adopte une voie alternative en recourant à la résine d'enrobage. Certes ce matériau est moins efficace thermiquement, mais l'on peut former des canaux de grande section si besoin ; et il reste possible de bénéficier de parois de canaux en matériaux bons conducteurs thermiques, comme la paroi supérieure de la puce, généralement faite à base de silicium, ou encore, dans un cas non limitatif, comme un revêtement sur la paroi de résine des canaux.

L'ouverture du circuit de refroidissement, par l'élimination du matériau sacrificiel, permet une circulation fluidique dans le circuit entre deux embouchures de ce circuit. Cette élimination, avantageusement opérée par fusion ou par dissolution, est simple et recourt aux embouchures nécessaires du circuit de refroidissement, ces dernières servant ainsi à la fois à la fabrication (pour éliminer le matériau sacrificiel) et au refroidissement (pour admettre et évacuer un fluide de refroidissement).

Un autre aspect séparable de l'invention est un mode de réalisation dans lequel la fabrication du circuit de refroidissement est collective, c'est-à-dire faite sur la base d'un support commun à plusieurs puces ; la phase de singularisation des puces produit de préférence en même temps un accès aux embouchures de chaque circuit, simplifiant grandement les étapes de réalisation.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- la figure 1 est une vue schématique de deux canaux pouvant être formés à la surface d'une puce pour constituer une partie d'un circuit de refroidissement ;
- la figure 2 est une vue en perspective d'une pluralité de puces disposées sur un support dans une situation de départ d'un mode de réalisation de l'invention ;
- les figures 3 à 8 représentent des étapes successives que l'on peut mettre en œuvre pour l'exécution de l'invention ;
- la figure 9 montre en perspective la formation collective d'une pluralité de circuit de refroidissement, chacun associé à un puce sur la face supérieure d'un support, tel qu'un substrat de type « wafer » ;
- les figures 10a à 10e présentent un mode de réalisation de l'invention avec une couche de recouvrement des canaux.

Les dessins sont donnés à titre d'exemples et ne sont pas limitatifs de l'invention.

Ils constituent des représentations schématiques de principe destinées à faciliter la compréhension de l'invention et ne sont pas nécessairement à l'échelle des applications pratiques. En particulier, les épaisseurs relatives des couches ne sont pas représentatives de la réalité.

### DESCRIPTION DETAILLEE

Avant d'entrer dans le détail descriptif de modes de réalisation possibles de l'invention, on énonce ci-après des options que l'invention peut comprendre, ces options n'étant données qu'à titre indicatif, sans caractère limitatif, et ces options pouvant être mises en œuvre individuellement ou selon toute combinaison entre elles :
- l'élimination comprend une fusion ou une dissolution du matériau sacrificiel ;
- le circuit 2 de refroidissement comprend une première embouchure 21 et une deuxième embouchure 22, l'élimination comprenant une injection d'un fluide par la première embouchure 21 et une expulsion du matériau sacrificiel par la deuxième embouchure 22 ;

- la procédé comprend la formation d'au moins une première ouverture au travers de l'enrobage 6 configurée pour former un accès (de fluide entrant) au motif 4, l'élimination comprenant une injection d'un fluide par la au moins une première ouverture, et/ou le procédé comprend la formation d'au moins une deuxième ouverture au travers de l'enrobage 6 configurée pour former un accès (de fluide sortant) au motif 4, l'élimination comprenant une expulsion du matériau sacrificiel par la au moins une deuxième ouverture ; dans ce cas, les ouvertures en question sont avantageusement distinctes des embouchures du circuit de refroidissement. Il peut y avoir plusieurs premières ouvertures et/ou plusieurs deuxièmes ouvertures ; on peut combiner différents types d'ouvertures : certaines (au moins une) uniquement dédiées à l'injection ou à l'élimination, avec des ouvertures (au moins une) réalisées par une embouchure du circuit de refroidissement ; en effet, une telle embouchure est un mode particulier d'ouverture au sens large pour les étapes d'injection et/ou d'élimination. Au moins une première ou deuxième ouverture peut être refermée respectivement après l'injection ou l'élimination.
- la formation dudit motif comprend la formation de l'au moins une couche d'un matériau sacrificiel 42 sur la première face de la puce, puis la formation d'au moins une deuxième couche 43 sur l'au moins une couche de matériau sacrificiel 42, l'au moins une deuxième couche 43 étant configurée pour ne pas être éliminée lors de l'élimination du matériau sacrificiel ;
- la formation dudit motif comprend la formation d'au moins une couche préliminaire sur la première face 10 de la puce 1, puis la formation de l'au moins une couche d'un matériau sacrificiel 42 sur la couche préliminaire, l'au moins une couche préliminaire étant configurée pour ne pas être éliminée lors de l'élimination du matériau sacrificiel ;
- le procédé comprend un assemblage de la puce, par une deuxième face de la puce opposée à la première face de la puce, sur une première face 30 d'un support 3 avant la réalisation du circuit de refroidissement ;
- une formation d'une couche de recouvrement sur la première face 30 du support 3 configurée pour ne laisser exposée de la puce 1 que sa première face 10;
- la formation dudit motif comprend la formation d'une première portion 40 de motif sur la première face de la puce 1 et la formation d'une deuxième portion 41 de motif sur une zone adjacente à la première face de la puce 1, notamment sur la face exposée de la couche de recouvrement 5 ;
- l'assemblage sur la première face 30 du support 3 et le circuit de refroidissement sont réalisés pour une pluralité de puces 1;
- la formation de la deuxième portion 41 de motif est configurée pour raccorder les deux premières portions de motif associées à des puces 1 différentes de la pluralité de puces 1 ;
- une séparation de portions du support comprenant chacune au moins une puce 1 de la pluralité de puces, après la formation de l'enrobage 6 et avant l'élimination du matériau sacrificiel ;
- la séparation est configurée pour couper les deuxièmes portions de motif de sorte à produire la première embouchure 21 et/ou la deuxième embouchure 22 d'au moins une puce 1 de la pluralité de puces.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou du substrat de puce, ou du support, se mesure selon une direction perpendiculaire à la surface selon laquelle cette couche ou ce substrat ou ce support présente son extension maximale. Une direction latérale s'entend comme dirigée perpendiculairement à l'épaisseur.

A moins qu'il n'en soit disposé autrement, les caractéristiques décrites en référence à un mode de réalisation de l'invention sont utilisables dans d'autres modes de réalisation.

Avant d'entrer dans la description correspondante aux modes de réalisation présentés dans les figures, il est précisé que l'invention peut être utilisée dans différents contextes. En effet, l'invention peut être mise en œuvre pour des puces disposées collectivement sur une plaque de substrat, généralement dénommée « wafer » avant découpage conventionnel et packaging des puces ; elle peut aussi être mise en œuvre à l'échelle individuelle de chaque puce. L'invention s'applique aussi à des structures de dispositifs micro-électroniques plus complexes que des puces individuelles, en particulier pour des empilements de composants sur un support, par exemple du type carte à circuits imprimés (connue en anglais sous l'acronyme PCB pour « Printed Circuit Board ») ; dans ce contexte, la zone de création du circuit de refroidissement par des canaux définis dans de la résine peut se situer par exemple dans un espace interstitiel entre la carte et un niveau supérieur du système complet, ou encore en face supérieure du système lui-même. Dans un autre cas de système complexe, une pluralité de puces peut-être packagée dans un seul boîtier en résine puis rapportée sur une plaque de connexion, par exemple du type PCB. Notamment, la technique de boîtiers dénommée « 3D fan-out packaging » entre dans le cadre de l'invention, dans la mesure où elle dispose de volumes assez importants d'enrobage en résine, favorables à l'application de l'invention.

En résumé, d'une manière générale, l'invention s'adresse d'une part à des fabrications collectives de puces et d'autre part à des phases de fabrication individuelles. Par ailleurs, elle s'adresse autant à des dispositifs micro-électroniques finaux ne comportant qu'une seule puce qu'à des dispositifs plus complexes comportant une association de puces en juxtaposition et/ou en superposition et/ou une association d'au moins une puce avec d'autres composants, par exemple une carte à circuits imprimés, une base de raccordement électrique ou un interposeur.

L'invention permet de définir un circuit de refroidissement. Cette définition s'entend que la forme et l'emplacement du circuit (des canaux notamment) sont déterminés à certains endroits et en particulier au niveau des cavités dans un enrobage en résine, et en regard d'une face de la puce. Cette définition d'un circuit en cavité (en creux dans l'enrobage et en regard de la puce) n'exclut pas qu'une ou des couches recouvrent, au niveau du circuit, la résine d'enrobage et/ou la face de la puce.

Un aspect de l'invention est d'utiliser un matériau polymère, une résine, pour définir le contour de l'ensemble de la partie du circuit de refroidissement au-dessus de la première face de la puce. Ainsi, l'enrobage dispose d'une forme tridimensionnelle, avec une paroi formant un relief en saillie sur la première face de la puce 1 et une paroi fermant les canaux du circuit de refroidissement, par leur côté supérieur, opposé à la face de la puce. Même si les parois du circuit de refroidissement peuvent être recouvertes par d'autres matériaux, ils sont ainsi structurellement définis par une enveloppe réalisée entièrement par la couche de résine, au-dessus de la première face de la puce, y compris suivant la direction en hauteur du circuit, correspondant à une dimension en épaisseur du substrat et à une dimension perpendiculaire à la première face de la puce. Il n'est donc plus nécessaire d'avoir recours à des parois verticales de canaux réalisées par électrodéposition de métal selon des technologies existantes.

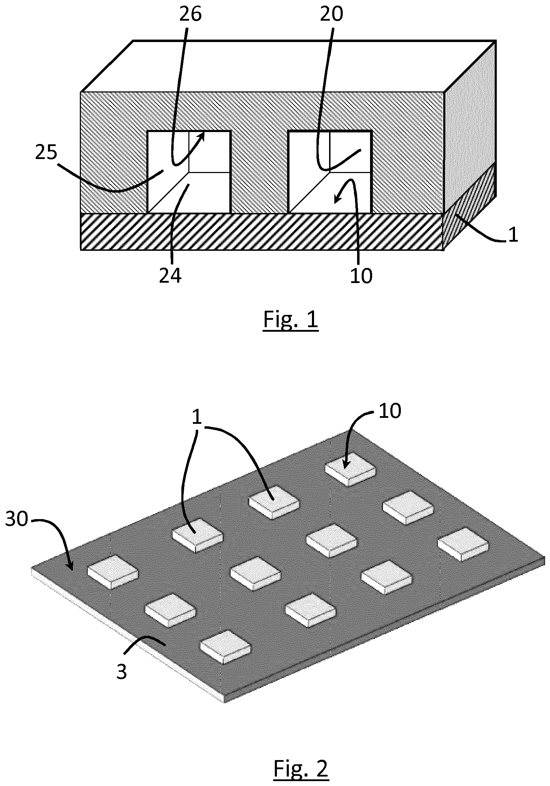

La figure 1 montre une vue partielle de la constitution de canaux 20 pouvant servir à créer un circuit de refroidissement au-dessus d'une première face 10 d'une puce 1. L'invention ne fait pas d'hypothèse sur les technologies de puces 1. Notamment, ces dernières seront avantageusement basées sur des matériaux de type semi-conducteur, par exemple à base de silicium. La première face 10 de la puce sera typiquement celle opposée à une face de connexion électrique comportant des éléments de raccordement électrique. La première face 10 est représentée de manière plane et homogène mais cet exemple n'est pas limitatif ; il peut s'agir d'une portion électriquement isolante mais thermiquement bonne conductrice ; notamment, des dissipateurs thermiques peuvent être présents à cet endroit.

À cette figure, on note que les canaux 20 sont définis au-dessus du matériau de la puce en elle-même, avec, préférentiellement, une paroi de fond 24 formée par une portion de la face 10 de la puce 1, une paroi supérieure 26 et une paroi latérale 25, double ; la description qui suit en référence aux étapes de fabrication illustrées à partir de la figure 2 explique comment sont définies les parois latérales et supérieure.

La figure 2 montre un exemple de disposition initiale d'une pluralité de puces 1 sur un support 3, la deuxième face des puces, opposée à leur première face 10, étant montée sur une première face 30 du support 3. Ce support peut être un substrat ou une base de raccordement électrique, par exemple une matrice de plots de raccordement de type grille de billes (ayant pour acronyme BGA, de l'anglais « Ball Grid Array »).

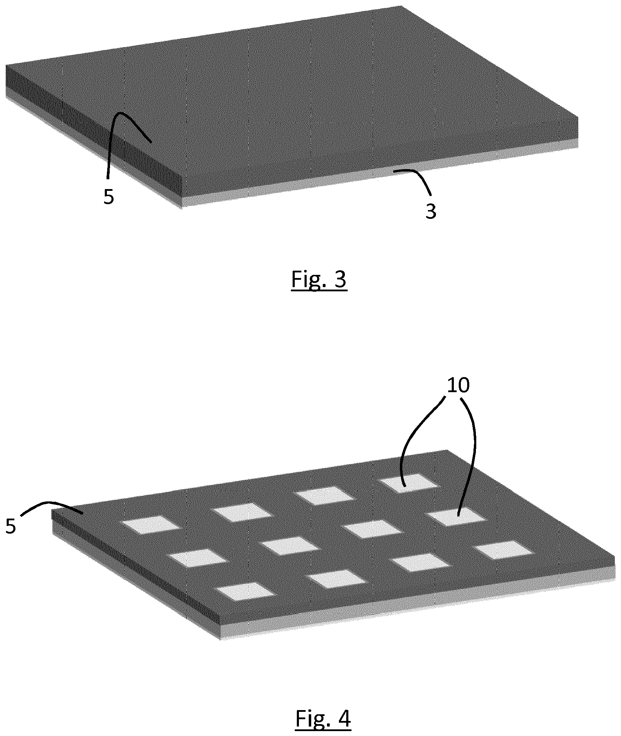

Sur cette base, on peut procéder, conformément à la figure 3, à une encapsulation des puces 1. On peut notamment utiliser une injection d'un produit encapsulant, typiquement une résine, et par exemple une résine époxy. Le recouvrement s'étend avantageusement sur l'ensemble de la première face 30 du support 3 et submerge avantageusement totalement les puces 1. Le produit encapsulant est ensuite réticulé de sorte à produire un moulage stable et solide sous forme d'une couche de recouvrement présentée sous la référence numérique 5.

Un amincissement de la couche 5 permet d'exposer les premières faces 10 des puces. On pourra utiliser une technique de planarisation pour réaliser l'amincissement, notamment par meulage, en arrêtant l'abrasion lorsque la première face 10 des puces est atteinte. Le résultat de cette étape représenté à la figure 4 est avantageux dans la mesure où l'on dispose d'une surface supérieure de la couche de recouvrement 5 plane et en alignement avec la première face 10 des puces. On verra que cela est utile pour la formation du circuit de refroidissement. Une physionomie de couche de recouvrement 5, équivalente à celle de la figure 4, peut être obtenue par d'autres méthodes que le recouvrement complet et l'amincissement ; en particulier, on peut aussi procéder à un moulage, une partie du moule étant mise directement au contact de la première face des puces ; elles ne sont alors pas recouvertes, mais la matière de moulage les entoure et recouvre la première face 30 du support.

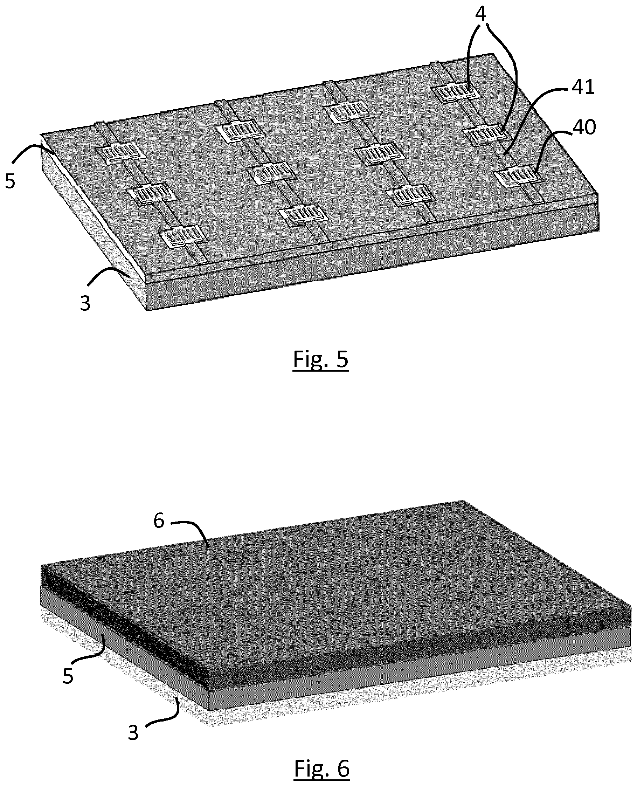

Sur cette base, on peut créer des motifs 4 qui vont permettre de définir la géométrie des circuits de refroidissement 2 associés aux puces 1. C'est l'objet de la représentation graphique de la figure 5. Au moins une portion de la première face 10 de chaque puce y est recouverte d'un motif, correspondant à la première portion de motif référencée au repère 40. Une autre partie des motifs 4 correspond à une deuxième portion 41 s'étendant de part et d'autre des premières portions 40 et permettant notamment de raccorder les premières portions 40. D'une manière générale, une première portion 40 forme un circuit de passage fluidique au-dessus de de la puce correspondante. Elle peut comprendre une pluralité de canaux 20, de préférence parallèles, les canaux se rejoignant à leurs extrémités par des parties de collecteurs de fluide. On comprend qu'un premier collecteur permet l'admission de fluide dans les canaux alors qu'un deuxième, de préférence situé à l'opposé du premier, assure la sortie fluidique.

Suivant l'invention, on utilise un matériau sacrificiel pour former, au moins en partie, une partie de l'épaisseur du motif. Ainsi, dans une autre phase du procédé, l'évacuation du matériau sacrificiel définira en creux le circuit de refroidissement.

Dans une première approche, l'évacuation du matériau sacrificiel s'opère par sa fusion ; dans ce contexte, on utilisera avantageusement des matériaux présentant un point de fusion assez bas, et de préférence éloigné d'une température de détérioration de la puce. Dans le même temps, il est souhaité que le point de fusion soit au-delà de la température de cuisson des résines utilisées pour l'enrobage. Par exemple, des matériaux métalliques, notamment des alliages, peuvent donner satisfaction. À titre préféré, il peut s'agir de pâtes d'alliage adaptées à la sérigraphie, telle que SnAg, SnAgCu, SnZn... par exemple, un alliage comprenant 96,5% d'étain et 3,5% d'argent offrent un point de fusion satisfaisant autour de 225°C. On peut également citer les alliages à point de fusion plus bas (120-200°C), composés d'un mélange d'indium, étain, bismuth. Ceux-ci seront à utiliser avec des résines de moulage epoxy à température de réticulation plus basse (80-120°C par exemple).

Dans une autre approche, l'évacuation du matériau sacrificiel s'opère par sa dissolution ; c'est le fluide issu de la dissolution qui permet d'évacuer le matériau sacrificiel ; dans ce contexte, on pourra utiliser tout matériau facilement soluble sans pour autant détériorer ou solubiliser les matériaux environnants. On pourra utiliser de la pâte à papier, du sucre, du sel ou encore des mousses poreuses.

L'utilisation de mousses poreuses ouvre le champ à de très nombreux matériaux, on citera les polymères poreux et les mousses métalliques. La porosité permet des durées de gravure réduites par rapport à un matériau plein en facilitant la circulation de la chimie à travers les pores : solvant (par ex. acétone) pour les polymères et acide (par ex. eau régale) pour les métaux. L'utilisation d'une couche d'encapsulation 43 du matériau sacrificiel peut dans ce cas également servir à isoler la chimie de gravure de la résine d'enrobage. On utilisera dans ce cas un procédé de dépôt de la couche 43 non ou peu conforme, comme le laminage afin de ne pas épouser la forme des pores. Dans le cas où l'on n'utilise pas de couche d'encapsulation 43, on adaptera le matériau sacrificiel avec la résine d'enrobage. Ainsi on choisira une résine d'enrobage avec une taille de « fillers » (communément des particules de silice) si possible supérieure à la taille des pores du matériau sacrificiel et une viscosité élevée afin de ne pas remplir les pores de résine.

Les motifs 4 sont formés en reliefs saillants au-dessus des premières faces 10 des puces 1 et de la couche de recouvrement 5. En particulier, il ne s'agit pas de portions creusées dans les puces, si bien qu'il n'est pas nécessaire de recourir à des étapes de photolithographie et de gravure de matériau du type silicium pour réaliser les canaux de l'invention.

On pourra notamment utiliser des procédés du type sérigraphie. Notamment, un masque dessiné définit les formes de motif désirées. Une impression utilisant une pâte de sérigraphie est ensuite mise en œuvre. On peut aussi recourir à de l'impression 2D ou de l'impression 3D ou encore à un dépôt électrochimique (par exemple pour les matériaux métalliques). L'impression 3D présente l'avantage de pouvoir réaliser un circuit de refroidissement tridimensionnel en une seule étape alors qu'il faudra avoir recourt à plusieurs niveaux de masque et plusieurs encapsulations pour réaliser le même circuit tridimensionnel avec un procédé de type sérigraphie.

À l'étape correspondant à la figure 6, on forme un enrobage 6. Potentiellement, il est réalisé avec un matériau équivalent à celui de la couche de recouvrement 5. Le matériau employé est préférentiellement une résine, par exemple une résine époxy. L'enrobage 6 est configuré pour recouvrir l'intégralité des motifs 4 formés en surplomb de la face supérieure de la couche de recouvrement 5. À titre d'exemple, l'épaisseur de la couche d'enrobage 6 peut-être supérieure 10 µm, voire bien supérieure, par exemple de plus de 100 µm. La réalisation de l'enrobage 6 peut être similaire à ce qui a été indiqué pour la couche 5, une injection de matière sous forme de résine liquide puis une réticulation par un recuit pouvant être mises en œuvre. Avantageusement, les matières de la couche 5 et de la couche 6 seront fusionnées de sorte à produire un ensemble cohérent et monobloc.

On notera que l'enrobage 6 assure le recouvrement des motifs tout en constituant préférentiellement une couche de packaging de chaque puce.

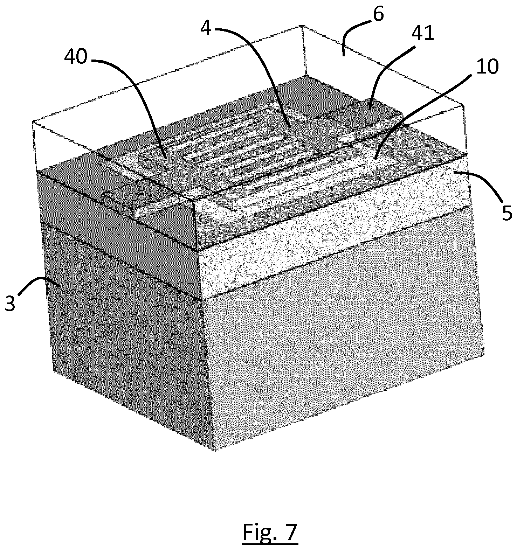

On peut alors procéder à une séparation des puces 1, en particulier par un découpage conventionnel. Avantageusement, la découpe est opérée de sorte à exposer des parties qui vont servir d'entrée et de sortie aux canaux 20 du circuit de refroidissement 4. La figure 7 montre en effet qu'une puce, avec une portion correspondante du support 3, de la couche de recouvrement 5 et de l'enrobage 6, a été séparée des autres. La couche 6 est représentée en transparence de sorte à laisser apparaître le motif 4 sous-jacent. Des canaux parallèles précédemment décrits y sont présents et leurs extrémités se rejoignent au niveau de deux portions 40, 41 de collection de fluide dont l'une va servir à l'entrée de fluide et l'autre à la sortie. Le découpage a ici été configuré de sorte à exposer, suivant l'épaisseur de l'enrobage 6, la tranche des première et deuxième portions 40, 41.

On dispose alors d'une entrée et d'une sortie pour procéder à l'élimination du matériau sacrificiel formant au moins partiellement le motif 4. Ainsi, la première entrée 40 peut être raccordée par une canalisation pressurisée de liquide ou de gaz (par exemple de l'azote, notamment une pression comprise entre 1 et 2 MPa, tel que 1,4 MPa). On procède alors, dans le cas d'un mode de réalisation par fusion, à un échauffement, par exemple en plaçant l'ensemble comprenant la puce dans un four et en le portant au-dessus du point de fusion du matériau sacrificiel. Dans le cas indiqué précédemment d'alliage d'étain et d'argent, une température de 250°C donne satisfaction. L'injection d'un fluide par la première portion 40 (ou la deuxième 41) permet de propulser le matériau sacrificiel en fusion vers la deuxième portion 41 (ou la première 40) formant ainsi une sortie du circuit d'élimination du matériau sacrificiel. Ce dernier peut être recyclé, notamment s'il s'agit d'un métal fusible. On pourra notamment choisir des matériaux sacrificiels présentant une température de fusion comprise entre 200 et 240°C. Dans l'option d'élimination du matériau sacrificiel par dissolution, on peut par exemple admettre une solution liquide aqueuse par la première portion 40, dissoudre progressivement le matériau sacrificiel le long des canaux, et procéder à l'évacuation de la solution par la deuxième portion 41.

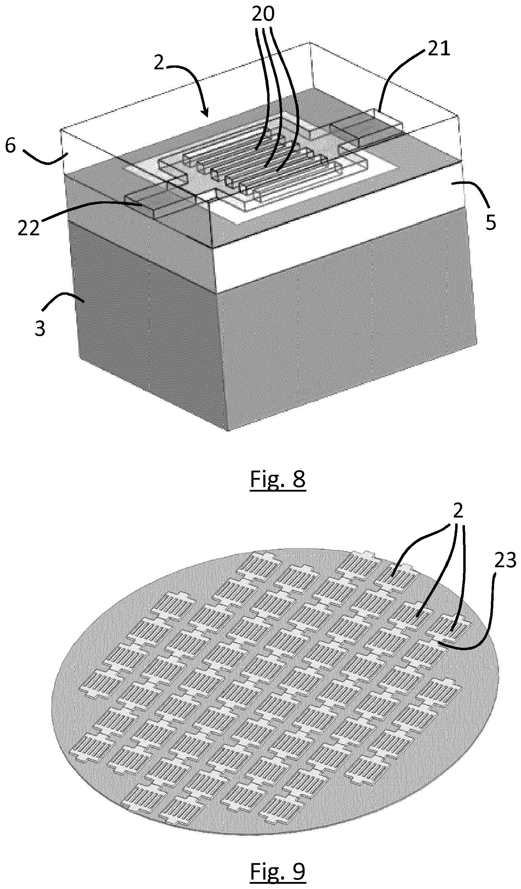

La figure 8 présente le résultat de l'élimination du matériau sacrificiel en révélant, en transparence au travers de la couche d'enrobage 6, un circuit de refroidissement 2, comportant dans l'exemple une pluralité de canaux 20, entre une première embouchure 21 et une deuxième embouchure 22. On comprend de ce qui précède que le circuit 2 a une hauteur, suivant la dimension en épaisseur des couches et de la puce, réalisée en creux dans la matière de l'enrobage 6. Ainsi, l'invention repose sur l'excavation du matériau d'enrobage, au-dessus de la puce grâce au matériau sacrificiel.

On notera qu'il n'est pas absolument nécessaire d'éliminer la totalité du matériau sacrificiel. Par exemple, une partie résiduelle du matériau sacrificiel peut subsister au niveau d'au moins l'une des parois du circuit 2. Ces résidus permettent éventuellement d'augmenter la conductivité thermique du circuit, ou encore de protéger les matériaux environnants, et notamment la résine d'enrobage 6, des agressions extérieures, par exemple celles dues au fluide de refroidissement. Par contre, l'élimination doit permettre d'ouvrir le circuit de refroidissement, c'est-à-dire d'assurer une communication fluidique entre la première embouchure 21 et la deuxième embouchure 22.

Le mode de réalisation correspondant à l'enchaînement des figures 2 à 8 est une fabrication collective sur la base d'un support du type BGA. On peut aussi atteindre le résultat de la figure 8 en traitant les puces de manière individuelle. Dans l'illustration de la figure 9, on a produit un procédé collectif pour une pluralité de puces 2 sur la base d'un substrat de type « wafer ». On y a par ailleurs illustré une zone de séparation 23 au niveau de laquelle la singularisation des puces permet également d'ouvrir les extrémités des première et deuxième portions 40, 41 des motifs qui vont servir à la formation des embouchures 21, 22. Une variante est possible même en l'absence de zones 41. On perce le moulage par la couche 6 afin d'atteindre le motif du circuit en formant des ouvertures (au moins une première ouverture pour l'entrée de fluide et/ou au moins une deuxième ouverture pour la sortie), par exemple au niveau de distributeurs de microcanaux. On laisse ainsi les parois latérales unies et sans cavités après la découpe. Les entrées et les sorties sont donc avantageusement verticales (selon l'épaisseur de la puce) pour ce scénario. Elles traversent de part en part l'épaisseur de l'enrobage 6. Dans le cas d'une élimination par fusion, au moins une deuxième ouverture peut suffire, simplement pour éliminer le matériau en phase liquide.

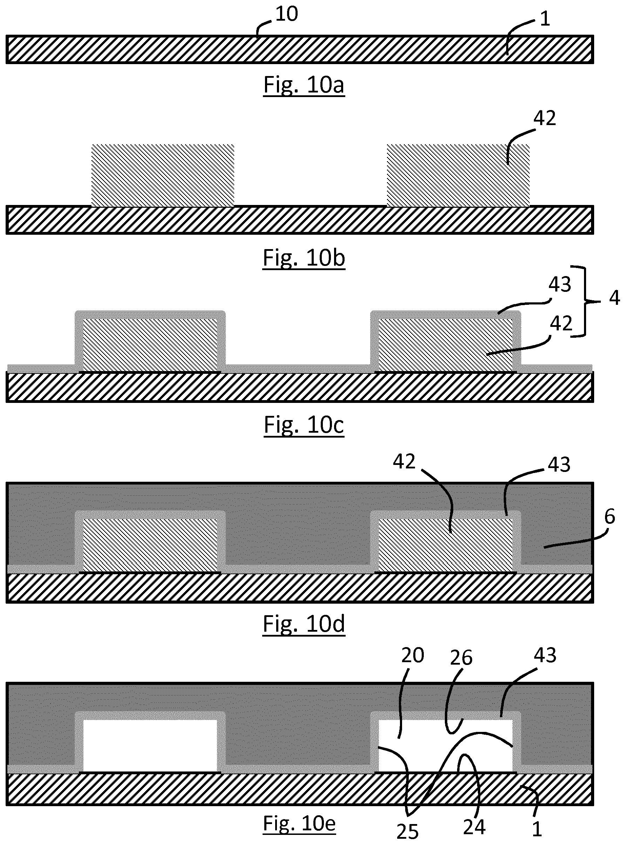

Les figures 10a à 10e donnent un autre exemple de configuration des motifs 4 et du procédé de l'invention.

La figure 10a montre schématiquement une coupe d'une puce 1, au niveau de sa première face 10. À la figure 10b, des parties de motifs ont été construites, sous forme d'une couche 42 d'un matériau sacrificiel ; les portions représentées peuvent correspondre à la section des deux parties destinées à former des canaux. Bien entendu, la couche 42 peut être composée d'une pluralité de sous-couches déposées successivement.

Ensuite, une deuxième couche 43 est formée de sorte à recouvrir la couche de matériau sacrificiel 42, l'ensemble de couches formant la définition complète du motif 4. Bien entendu, la deuxième couche 43 peut être composée d'une pluralité de sous-couches déposées successivement. Dans le cas représenté, la deuxième couche 43 recouvre intégralement la couche 42, mais ce n'est pas absolument nécessaire. En outre, dans l'exemple représenté, la couche 43 recouvre aussi la première face 10 de la puce, en dehors de la couche 42, mais ce n'est pas absolument nécessaire.

Par exemple, la deuxième couche 43 peut être déposée par des techniques de dépôt chimique ou physique en phase vapeur ; la technique utilisée dépendra des matériaux souhaités. Le matériau de la couche 43 peut être un meilleur conducteur thermique que la résine d'enrobage et/ou un matériau étanche à l'eau.

À la figure 10d, on a procédé à la formation de l'enrobage 6 comme précédemment. Ce dernier se trouve au contact de la deuxième couche 43 ; avantageusement, le matériau sacrificiel de la couche 42 se trouve isolé de la résine d'enrobage 6. Comme précédemment, le matériau sacrificiel 42 est éliminé de sorte à produire une excavation au sein du volume de l'enrobage 6 ; la figure 10e en donne le résultat. Cette fois, les parois latérales 25 et la paroi supérieure 26, notamment des canaux 20, correspondent au matériau de la deuxième couche 43. Comme précédemment, la paroi de fond 24 correspond au matériau de la première face 10 de la puce. On notera que l'enrobage 6 recouvre à la fois les flancs (dirigés avec une composante non nulle suivant la dimension en épaisseur du substrat) et le sommet des motifs (qui est la partie la plus élevée de ces motifs, qui est par exemple une face supérieure de motifs, qui peut-être plane et éventuellement parallèle à la première face 10. L'enrobage 6 forme une enveloppe continue et intégrale de part et d'autre du motif défini par le matériau sacrificiel 42 au-dessus de la première face 10.

D'une manière générale, la deuxième couche 43 peut remplir au moins l'une des fonctions suivantes :
- Augmenter la conduction thermique entre le substrat et le fluide caloporteur ;
- Servir de barrière imperméable pour éviter l'altération ou le gonflement du moulage ;
- Agir en tant que barrière chimique si un caloporteur peut réagir avec le moulage ;
- Limiter l'érosion des parois du moulage ;
- Rendre la surface hydrophile pour éviter que des bulles d'air/gaz ne restent collées à la paroi pendant le refroidissement s'il est liquide.

Suivant une autre possibilité non illustrée, cumulable ou utilisable en alternative aux modes de réalisation correspondants aux figures 10a à 10e, une couche préliminaire peut être déposée avant la formation de la couche de matériau sacrificiel 42, de sorte à couvrir au moins partiellement la première face 10 de la puce.

À l'issue du process de l'invention, le dispositif micro-électronique ainsi constitué sur la base d'une puce 1 peut être refroidi par circulation d'un fluide de refroidissement, notamment liquide, dans le circuit 2.

Il est possible, pour la phase d'élimination du matériau sacrificiel, d'assembler une des embouchures 21, 22 à une canalisation d'admission de fluide. On peut par exemple installer un capillaire raccordé de manière étanche à l'embouchure correspondante. Avantageusement, cette canalisation est préservée et réutilisée pour admettre le fluide de refroidissement.

On notera que la section des portions constituant le circuit de refroidissement 2 peut-être importante ; par exemple, la hauteur des canaux peut atteindre plus de 50 microns, notamment entre 50 et 150 microns ; leur largeur est d'une manière générale supérieure à 30 microns, voire à 50 microns, et est notamment potentiellement comprise entre 50 et 1000 microns. De telles dimensions sont atteintes sans altérer, ni modifier les puces elles-mêmes.

### REFERENCES

- 1.: Puce
10. Première face
- 2.: Circuit de refroidissement
20. Canal
21. Première embouchure
22. Deuxième embouchure
23. Zone de séparation
24. Paroi de fond
25. Paroi latérale.
26. Paroi supérieure
- 3.: Support
30. Première face
- 4.: Motif de définition de circuit
40. Première portion
41. Deuxième portion
42. Couche de matériau sacrificiel
43. Deuxième couche
- 5.: Couche de recouvrement
- 6.: Enrobage

## Revendications

1. Procédé de fabrication d'un circuit de refroidissement sur au moins une puce (1) à circuits intégrés, comprenant une réalisation d'un circuit de refroidissement (2) sur une première face de la puce (1),
**caractérisé par le fait que** la réalisation du circuit de refroidissement (2) comprend :
- une formation d'un motif (4) de définition du circuit de refroidissement (2) situé au moins en partie sur la première face (10) de la puce (1), ledit motif comprenant au moins une couche d'un matériau sacrificiel (42) ;
- une formation d'un enrobage (6) dudit motif par au moins une couche de résine, l'enrobage (6) étant configuré pour recouvrir l'intégralité des motifs (4) ;
- une élimination, au moins partielle, du matériau sacrificiel dudit motif, de sorte à ouvrir le circuit de refroidissement (2).

2. Procédé selon la revendication 1, dans lequel l'élimination comprend une fusion ou une dissolution du matériau sacrificiel.

3. Procédé selon la revendication précédente, comprenant la formation d'au moins une première ouverture au travers de l'enrobage (6) configurée pour former un accès au motif (4), l'élimination comprenant une injection d'un fluide par la au moins une première ouverture, et/ou comprenant la formation d'au moins une deuxième ouverture au travers de l'enrobage (6) configurée pour former un accès au motif (4), l'élimination comprenant une expulsion du matériau sacrificiel par la au moins une deuxième ouverture.

4. Procédé selon l'une des deux revendications précédentes, dans lequel le circuit de refroidissement (2) comprend une première embouchure (21) et une deuxième embouchure (22), l'élimination comprenant une injection d'un fluide par la première embouchure (21) et une expulsion du matériau sacrificiel par la deuxième embouchure (22).

5. Procédé selon l'une des trois revendications précédentes, dans lequel l'élimination comprend une fusion, le matériau sacrificiel choisi étant métallique, et de préférence un alliage d'argent et d'étain.

6. Procédé selon l'une des revendications précédentes, dans lequel la formation dudit motif comprend la formation de l'au moins une couche d'un matériau sacrificiel (42) sur la première face (10) de la puce (1), puis la formation d'au moins une deuxième couche (43) sur l'au moins une couche de matériau sacrificiel (42), l'au moins une deuxième couche (43) étant configurée pour ne pas être éliminée lors de l'élimination du matériau sacrificiel.

7. Procédé selon l'une des revendications précédentes, dans lequel la formation dudit motif comprend la formation d'au moins une couche préliminaire sur la première face (10) de la puce (1), puis la formation de l'au moins une couche d'un matériau sacrificiel (42) sur la couche préliminaire, l'au moins une couche préliminaire étant configurée pour ne pas être éliminée lors de l'élimination du matériau sacrificiel.

8. Procédé selon l'une des revendications précédentes, comprenant un assemblage de la puce (1), par une deuxième face de la puce opposée à la première face (10) de la puce, sur une première face (30) d'un support (3) avant la réalisation du circuit de refroidissement, et de préférence une formation d'une couche de recouvrement (5) sur la première face (30) du support (3) configurée pour ne laisser exposée de la puce (1) que sa première face (10).

9. Procédé selon l'une des revendications précédentes, dans lequel la formation dudit motif comprend la formation d'une première portion (40) de motif sur la première face de la puce (1) et la formation d'une deuxième portion (41) de motif sur une zone adjacente à la première face de la puce (1).

10. Procédé selon la revendication 8, dans lequel l'assemblage sur la première face (30) du support (3) et le circuit de refroidissement (2) sont réalisés pour une pluralité de puces (1).

11. Procédé selon la revendication précédente en combinaison avec la revendication 9, dans lequel la formation de la deuxième portion (41) de motif (4) est configurée pour raccorder deux premières portions de motif associées à des puces (1) différentes de la pluralité de puces (1), et de préférence comprenant une séparation de portions du support (3) comprenant chacune au moins une puce (1) de la pluralité de puces, après la formation de l'enrobage (6) et avant l'élimination du matériau sacrificiel, et de préférence dans lequel la séparation est configurée pour couper les deuxièmes portions de motif de sorte à produire la première embouchure (21) et/ou la deuxième embouchure (22) d'au moins une puce (1) de la pluralité de puces.

12. Dispositif microélectronique comprenant au moins une puce (1) à circuits intégrés, un circuit de refroidissement (2) et un support (3), le circuit de refroidissement (2) étant situé sur une première face (10) de la puce (1), la puce (1) étant assemblée par une deuxième face de la puce, opposée à la première face de la puce, à une première face (30) du support (3), les parois du circuit de refroidissement (2) étant définies, pour une première des parois par la première face (10) de la puce (1), et pour toutes les autres parois par des canaux (20) formés en creux dans un enrobage (6) en résine.

13. Dispositif selon la revendication précédente, dans lequel les canaux (20) sont revêtus d'une couche superficielle.

14. Dispositif selon l'une des deux revendications précédentes, dans lequel le circuit de refroidissement comprend au moins un canal (20) de dimension en épaisseur d'au moins 30µm, voire d'au moins 50µm.

15. Dispositif selon l'une des trois revendications précédentes, dans lequel l'enrobage (6) en résine est un boitier de couverture de la puce (1).

## Patentansprüche

1. Verfahren zur Herstellung eines Kühlkreislaufs auf mindestens einem Chip (1) mit integrierten Schaltkreisen, umfassend eine Fertigung eines Kühlkreislaufs (2) auf einer ersten Seite des Chips (1),
**dadurch gekennzeichnet, dass** die Fertigung eines Kühlkreislaufs (2) umfasst:
- eine Bildung eines Motivs (4) zum Definieren des Kühlkreislaufs (2), das mindestens teilweise auf der ersten Seite (10) des Chips (1) gelegen ist, wobei das Motiv mindestens eine Schicht eines Opfermaterials (42) umfasst;
- eine Bildung eines Überzugs (6) des Motivs durch mindestens eine Harzschicht, wobei der Überzug (6) konfiguriert ist, um die Gesamtheit des Motivs (4) abzudecken;
- eine mindestens teilweise Entfernung des Opfermaterials von dem Motiv, um den Kühlkreislauf (2) zu öffnen.

2. Verfahren nach Anspruch 1, wobei die Entfernung ein Schmelzen oder Auflösen des Opfermaterials umfasst.

3. Verfahren nach dem vorstehenden Anspruch, die Bildung mindestens einer ersten Öffnung durch den Überzug (6) hindurch umfassend, die konfiguriert ist, um einen Zugang zu dem Motiv (4) zu bilden, wobei die Entfernung eine Injektion eines Fluids durch die mindestens eine erste Öffnung hindurch umfasst, und/ oder die Bildung mindestens einer zweiten Öffnung durch den Überzug (6) hindurch umfasst, die konfiguriert ist, um einen Zugang zu dem Motiv (4) zu bilden, wobei die Entfernung einen Ausstoß des Opfermaterials durch die mindestens eine zweite Öffnung hindurch umfasst.

4. Verfahren nach einem der beiden vorstehenden Ansprüche, wobei der Kühlkreislauf (2) eine erste Mündung (21) und eine zweite Mündung (22) umfasst, wobei die Entfernung eine Injektion eines Fluids durch die erste Mündung (21) hindurch und deinen Ausstoß des Opfermaterials durch die zweite Mündung (22) hindurch umfasst.

5. Verfahren nach einem der drei vorstehenden Ansprüche, wobei die Entfernung eine Schmelzung umfasst, wobei das ausgewählte Opfermaterial metallisch ist und vorzugsweise eine Silber- und Zinnlegierung ist.

6. Verfahren nach einem der vorstehenden Ansprüche, wobei die Bildung des Motivs die Bildung der mindestens einen Schicht eines Opfermaterials (42) auf der ersten Seite (10) des Chips (1), danach die Bildung mindestens einer zweiten Schicht (43) auf der mindestens einen Schicht aus Opfermaterial (42) umfasst, wobei die mindestens eine zweite Schicht (43) konfiguriert ist, um bei der Entfernung des Opfermaterials nicht entfernt zu werden.

7. Verfahren nach einem der vorstehenden Ansprüche, wobei die Bildung des Motivs die Bildung mindestens einer Vorbereitungsschicht auf der ersten Seite (10) des Chips (1), danach die Bildung der mindestens einen Schicht eines Opfermaterials (42) auf der Vorbereitungsschicht umfasst, wobei die mindestens eine Vorbereitungsschicht konfiguriert ist, um bei der Entfernung des Opfermaterials nicht entfernt zu werden.

8. Verfahren nach einem der vorstehenden Ansprüche, umfassend die Zusammensetzung des Chips (1) durch eine zweite Seite des Chips gegenüber der ersten Seite (10) des Chips, auf einer ersten Seite (30) einer Halterung (3) vor der Fertigung des Kühlkreislaufs, und vorzugsweise eine Bildung einer Abdeckschicht (5) auf der ersten Seite (30) der Halterung (3), die konfiguriert ist, um von dem Chip (1) nur seine erste Seite (10) offengelegt zu lassen.

9. Verfahren nach einem der vorstehenden Ansprüche, wobei die Bildung des Motivs die Bildung eines ersten Motivabschnitts (40) auf der ersten Seite des Chips (1) und die Bildung eines zweiten Motivabschnitts (41) in einer an die erste Seite des Chips (1) angrenzenden Zone umfasst.

10. Verfahren nach Anspruch 8, wobei die Zusammensetzung auf der ersten Seite (30) der Halterung (3) und der Kühlkreislauf (2) für eine Vielzahl von Chips (1) realisiert werden.

11. Verfahren nach dem vorstehenden Anspruch, in Kombination mit Anspruch 9, wobei die Bildung des zweiten Abschnitts (41) eines Motivs (4) konfiguriert ist, um zwei erste Motivabschnitte, die unterschiedlichen Chips (1) der Vielzahl von Chips (1) zugeordnet sind, anzuschließen, und vorzugsweise eine Trennung von Halterungsabschnitten (3) umfassend, die jeweils mindestens einen Chip (1) der Vielzahl von Chips umfassen, nach der Bildung des Überzugs (6) und vor der Entfernung des Opfermaterials, und wobei die Trennung vorzugsweise konfiguriert ist, um die zweiten Motivabschnitte derart zu schneiden, um die erste Mündung (21) und/ oder die zweite Mündung (22) mindestens eines Chips (1) der Vielzahl von Chips zu erzeugen.

12. Mikroelektronische Vorrichtung, mindestens einen Chip (1) mit integrierten Schaltkreisen, einen Kühlkreislauf (2) und eine Halterung (3) umfassend, wobei der Kühlkreislauf (2) auf einer ersten Seite (10) des Chips (1) gelegen ist, wobei der Chip (1) durch eine zweite Seite des Chips gegenüber der ersten Seite des Chips, auf einer ersten Seite (30) der Halterung (3) zusammengesetzt ist, wobei die Wände des Kühlkreislaufs (2) für eine erste der Wände durch die erste Seite (10) des Chips (1), und für die anderen Wände durch Kanäle (20) definiert sind, die vertieft in einem Überzug (6) aus Harz gebildet sind.

13. Vorrichtung nach dem vorstehenden Anspruch, wobei die Kanäle (20) mit einer Oberflächenschicht überzogen sind.

14. Vorrichtung nach einem der beiden vorstehenden Ansprüche, wobei der Kühlkreislauf mindestens einen Kanal (20) in einer Dickenabmessung von mindestens 30 µm, oder gar mindestens 50 µm umfasst.

15. Vorrichtung nach einem der drei vorstehenden Ansprüche, wobei der Überzug (6) aus Harz ein Abdeckgehäuse des Chips (1) ist.

## Claims

1. A method for manufacturing a cooling circuit on at least one integrated circuit chip (1), comprising making a cooling circuit (2) on a first face of the chip (1), **characterised in that** making the cooling circuit (2) comprises:
- a formation of a pattern (4) for defining the cooling circuit (2) located at least partially on the first face (10) of the chip (1), said pattern comprising at least one layer of a sacrificial material (42);
- a formation of a coating (6) of said pattern by at least one resin layer, the coating (6) being configured to cover all patterns (4);
- an at least partial removal of the sacrificial material from said pattern, so as to open the cooling circuit (2).

2. The method according to claim 1, wherein the removal comprises melting or dissolving the sacrificial material.

3. The method according to the preceding claim, comprising the formation of at least one first opening through the coating (6) configured to form an access to the pattern (4), the removal comprising an injection of a fluid through the at least one first opening, and/or comprising the formation of at least one second opening through the coating (6) configured to form an access to the pattern (4), the removal comprising an expulsion of the sacrificial material through the at least one second opening.

4. The method according to one of the two preceding claims, wherein the cooling circuit (2) comprises a first mouthpiece (21) and a second mouthpiece (22), the removal comprising an injection of a fluid by the first mouthpiece (21) and an expulsion of the sacrificial material by the second mouthpiece (22).

5. The method according to one of the three preceding claims, wherein the removal comprises a melting, the selected sacrificial material being metal, and preferably a silver and tin alloy.

6. The method according to one of the preceding claims, wherein the formation of said pattern comprises the formation of the at least one layer of a sacrificial material (42) on the first face (10) of the chip (1), then the formation of at least one second layer (43) on the at least one sacrificial material layer (42), the at least one second layer (43) being configured not to be removed when removing the sacrificial material.

7. The method according to one of the preceding claims, wherein the formation of said pattern comprises the formation of at least one preliminary layer on the first face (10) of the chip (1), then the formation of the at least one layer of a sacrificial material (42) on the preliminary layer, the at least one preliminary layer being configured not to be removed when removing the sacrificial material.

8. The method according to one of the preceding claims, comprising an assembly of the chip (1), by a second face of the chip which is opposite to the first face (10) of the chip, on a first face (30) of a support (3) before making the cooling circuit, and preferably a formation of a cover layer (5) on the first face (30) of the support (3) which is configured to leave exposed of the chip (1) only the first face (10) thereof.

9. The method according to one of the preceding claims, wherein the formation of said pattern comprises the formation of a first pattern portion (40) on the first face of the chip (1) and the formation of a second pattern portion (41) on an area adjacent to the first face of the chip (1).

10. The method according to claim 8, wherein the assembly on the first face (30) of the support (3) and the cooling circuit (2) are made for a plurality of chips (1).

11. The method according to the preceding claim in combination with claim 9, wherein the formation of the second portion (41) of pattern (4) is configured to connect two first pattern portions associated with chips (1) which are different from the plurality of chips (1), and preferably comprising a separation of portions of the support (3) each comprising at least one chip (1) of the plurality of chips, after the formation of the coating (6) and before the removal of the sacrificial material, and preferably wherein the separation is configured to cut the second pattern portions so as to produce the first mouthpiece (21) and/or the second mouthpiece (22) of at least one chip (1) of the plurality of chips.

12. A microelectronic device comprising at least one integrated circuit chip (1), a cooling circuit (2) and a support (3), the cooling circuit (2) being located on a first face (10) of the chip (1), the chip (1) being assembled by a second face of the chip, opposite to the first face of the chip, to a first face (30) of the support (3), the walls of the cooling circuit (2) being defined, for a first wall of the walls by the first face (10) of the chip (1), and for all other walls by hollow-shaped channels (20) in a resin coating (6).

13. The device according to the preceding claim, wherein the channels (20) are coated with a surface layer.

14. The device according to one of the two preceding claims, wherein the cooling circuit comprises at least one channel (20) with a thickness dimension of at least 30 µm, or even at least 50 µm.

15. The device according to one of the three preceding claims, wherein the resin coating (6) is a case for covering the chip (1).
